# EUROPEAN PATENT APPLICATION

(11) **EP 2 562 806 A1**
(43) Date of publication of application: **27.02.2013**
(21) Application number: 11771938.5
(22) Date of filing: 14.04.2011
(51) Int. Cl.: H01L 23/32, H01L 23/15

(54) **GLASS SUBSTRATE FOR FORMING SEMICONDUCTOR DEVICE VIA**

(30) Priority: 20.04.2010 JP 2010097228
(71) Applicant: Asahi Glass Company, Limited, Tokyo 100-8405 (JP)
(72) Inventor: KOIKE Akio, Tokyo 100-8405 (JP); ONO Motoshi, Tokyo 100-8405 (JP); MURAKAMI Ryota, Tokyo 100-8405 (JP); KIKUGAWA Shinya, Tokyo 100-8405 (JP)
(74) Representative: Müller-Boré & Partner Patentanwälte
(86) International application number: PCT/JP2011/059320
(87) International publication number: WO 2011/132603

(57) **Abstract**

A glass substrate for forming a through-substrate via of a semiconductor device is provided, in which the α-ray emission is significantly suppressed and to which a laser beam machining is possible. The present invention is characterized in that a plurality of penetration holes is provided, and an α-count is 0.05 c/cm²·h or less, a SiO₂ content is 40 wt% or higher, and a sum total content of Li₂O (wt%) + Na₂O (wt%) + K₂O (Wt%) is 6.0 wt% or lower, and an average coefficient of thermal expansion at 50°C to 350°C is in a range of 20 x 10⁻⁷/K to 40 x 10⁻⁷/K.

## Description

### TECHNICAL FIELD

The present invention relates to a glass substrate for forming a through-substrate via of a semiconductor device.

### BACKGROUND ART

In order to cope with demands to increase the integration density of the printed circuit board due to high-density packaging, a multi-layer printed circuit board was developed in which a plurality of printed circuit boards are stacked. In such a multi-layer printed circuit board, micro penetration holes having a diameter on the order of 100 µm or less, called via holes, are formed in a resin insulator layer and the inside of the penetration holes is plated in order to electrically connect conductor layers of the printed circuit boards that are stacked one on top of the other.

As a method of facilitating the forming of such penetration holes, Patent Documents No. 1 and No. 2 propose irradiating laser light on the insulator layer via a mask having a large number of penetration openings. According to this proposed method, a plurality of penetration holes may be formed simultaneously in the resin insulator layer, and thus, the penetration holes (via holes) may be formed with ease. In addition, a Non-Patent Document No. 1 proposes using for the insulator layer a glass substrate having a plurality of penetration holes.

On the other hand, due to increased demands to reduce the size, increase the operation speed, and reduce the power consumption of semiconductor devices, a three-dimensional SiP (System in Package) technology was developed in which the SiP technology that accommodates a system including a plurality of LSIs (Large Scale Integrated circuits) in a single package, and the three-dimensional packaging technology, are combined. In this case, the wire-bonding technology is unable to cope with the narrow pitch, and an interposing substrate called an interposer using through-substrate vias may be required. It may be conceivable to use a glass substrate as the interposing substrate.

On the other hand, semiconductor devices such as a CMOS (Complementary Metal Oxide Semiconductor) sensor and a CCD (Charge Coupled Device), for example, are easily affected by α-rays emitted from a glass window of the package, and a soft error may be generated due to the α-rays. For this reason, the glass used in such semiconductor devices may be required to reduce the radioactive isotope emitting the α-rays, particularly the amount of U (uranium) and Th (thorium).

Under these observations, the Patent Documents Nos. 3 and 4 reported that the amount of the α-ray emission may be suppressed by using phosphate glass having a particular composition.

### PRIOR ART DOCUMENTS

### PATENT DOCUMENTS

Patent Document 1: Japanese Laid-Open Patent Publication No. 2005-88045
Patent Document 2: Japanese Laid-Open Patent Publication No. 2002-126886
Patent Document 3: Japanese Patent No. 3283722
Patent Document 4: Japanese Laid-Open Patent Publication No. 2005-353718

### NON-PATENT DOCUMENTS

Non-Patent Document 1: JPCA NEWS, p. 16 - p. 25, October 2009

### DISCLOSURE OF THE INVENTION

### PROBLEM TO BE SOLVED BY THE INVENTION

As described above, the Patent Documents Nos. 3 and 4 describe the phosphate glass that may suppress the amount of the α-ray emission. However, in general, the workability of phosphate glass is relatively poor, and it is relatively difficult to form the micro penetration holes by laser beam machining.

In addition, although the Patent Document No. 3 describes borosilicate glass capable of suppressing the amount of the α-ray emission, the coefficient of thermal expansion of borosilicate glass is 47 x 10⁻⁷/K or greater, which is considerably large compared to the coefficient of thermal expansion (approximately 33 x 10⁻⁷/K) of silicon. For this reason, when such borosilicate glass is used to form a part for forming the through-substrate via, such as the interposer, for example, the following problem occurs when the semiconductor device is formed by arranging a conductive part, such as a silicon chip, above and below the interposer. That is, when the semiconductor device receives a stress, a contact failure may occur between the conductive parts, or the semiconductor device itself may be damaged, due to the mismatch between the coefficient of thermal expansion of the glass substrate and the coefficient of thermal expansion of the silicon chip.

Accordingly, there is a problem in that it is extremely difficult to use the glass described in the Patent Documents Nos. 3 and 4 as the glass substrate for forming the through-substrate via.

The present invention is conceived in view of the above problem, and one object of the present invention is to provide a glass substrate for forming the through-substrate via of the semiconductor device, that may significantly suppress α-ray generation, enable laser beam machining, and have a high affinity with respect to silicon parts.

### MEANS OF SOLVING THE PROBLEM

The present invention may provide the following glass substrate for forming the through-substrate via of the semiconductor device.
(1) A glass substrate for forming a through-substrate via of a semiconductor device, characterized in that there are provided:
   a plurality of penetration holes,
   wherein an α-count is 0.05 c/cm²·h or less,
   a SiO₂ content is 40 wt% or higher, and a sum total content of Li₂O (wt%) + Na₂O (wt%) + K₂O (Wt%) is 6.0 wt% or lower, and
   an average coefficient of thermal expansion at 50°C to 350°C is in a range of 20 x 10⁻⁷/K to 40 x 10⁻⁷/K.
(2) The glass substrate according to (1), characterized in that the glass substrate includes substantially no barium.
(3) The glass substrate according to (1) or (2), characterized in that the glass substrate includes a sum total content of Li₂O (wt%) + Na₂O (wt%) + K₂O (Wt%) that is 3.5 wt% or lower.
(4) The glass substrate according to any of (1) to (3), characterized in that the glass substrate has a Young's modulus of 70 GPa or higher.
(5) The glass substrate according to any of (1) to (4), characterized in that the plurality of penetration holes have a tapered shape having a taper angle in a range of 0.1 ° to 20°.

### EFFECTS OF THE INVENTION

The present invention may provide a glass substrate for forming the through-substrate via of the semiconductor device, that may significantly suppress α-ray generation, enable laser beam machining, and have a high affinity with respect to silicon parts.

### BRIEF DESCRIPTION OF THE DRAWING

FIG. 1 is a cross sectional view, on an enlarged scale, illustrating an example of a penetration hole in a glass substrate of the present invention;
FIG. 2 is a diagram schematically illustrating an example of a structure of a manufacturing apparatus used by a manufacturing method of the present invention; and
FIG. 3 is a flow chart schematically illustrating the manufacturing method of the present invention.

### MODE OF CARRYING OUT THE INVENTION

A detailed description will hereinafter be given of the present invention.

The glass substrate for forming the through-substrate via of the semiconductor device in accordance with the present invention (hereinafter simply referred to as "glass substrate of the present invention") is characterized by including a plurality of penetration holes, having an α-count of 0.05 c/cm²·h or lower, including 40 wt% of SiO₂ or more, and having an average coefficient of thermal expansion in a range of 20 x 10⁻⁷/K to 40 x 10⁻⁷/K at 50°C to 350°C.

The α-count of the glass substrate of the present invention is 0.05 c/cm²·h or lower. Accordingly, even when the glass substrate of the present invention is used in a semiconductor device such as the CMOS (Complementary Metal Oxide Semiconductor) sensor or the CCD (Charge Coupled Device), for example, the soft error generation due to α-rays may be suppressed. The α-count is preferably 0.01 c/cm²·h or lower, and more preferably lower than 0.002 c/cm²·h.

The α-count may be measured using a commercially available α-ray measuring apparatus, such as an α-ray measuring apparatus (LACS) manufactured by Sumika Chemical Analysis Service, Ltd., for example. Such a measuring apparatus measures the α-rays from the sample surface using a proportional counter, and the α-count may be measured by converting a pulse current generated by ionization of a gas by the α-rays, and counting pulses greater than or equal to a threshold value.

In order to restrict the α-count to the range described above, the present invention minimizes the amount of radioactive isotope within the glass and emitting the α-rays, particularly the U (uranium) content and the Th (thorium) content. For example, in the glass substrate of the present invention, the U (uranium) content and the Th (thorium) content are both lower than 5 mass ppb. In addition, in the glass substrate of the present invention, the Ba (barium) content and/or the Zr (zirconium) content are extremely low and both are lower than 5 mass ppb. This is because, normally, there is a high possibility that low amounts of U (uranium) and Th (thorium) are included in the raw materials of Ba (barium) and Zr (zirconium).

In addition, the glass substrate of the present invention includes 40 wt% of SiO₂ or more. Hence, compared to the conventional phosphate glass, the glass substrate of the present invention enables laser beam machining to be performed relatively easily.

Furthermore, the substrate of the present invention has an average coefficient of thermal expansion (hereinafter simply referred to as "coefficient of thermal expansion") in the range of 20 x 10⁻⁷/K to 40 x 10⁻⁷/K at 50°C to 350°C. Hence, even when the glass substrate of the present invention is stacked on a silicon wafer, or a silicon chip is stacked on the glass substrate of the present invention, a separation between the glass substrate and the silicon wafer uneasily occurs, and a deformation of the silicon wafer uneasily occurs.

Particularly, the coefficient of thermal expansion of the glass substrate is preferably in a range of 25 x 10⁻⁷/K to 38 x 10⁻⁷/K, and more preferably in a range of 30 x 10⁻⁷/K to 35 x10⁻⁷/K. In this case, the separation and/or the deformation may further be suppressed. In a case in which the coefficient of thermal expansion of the glass substrate is to be matched to that of a resin substrate, such as a mother board, the coefficient of thermal expansion of the glass substrate is preferably in a range of 35 x 10⁻⁷/K to 40 x 10-⁷/K*.*

In the present invention, the average coefficient of thermal expansion at 50°C to 350°C refers to the value obtained based on JIS R3102 (year 1995) by performing the measurement using a differential thermal expansion analyzer (TMA).

By the features described above, the present invention may provide a glass substrate for forming a through-substrate via of a semiconductor device, which may significantly suppress the α-ray generation, enable the laser beam machining, and have a high affinity with respect to silicon parts.

The glass substrate of the present invention, in a normal case, has a thickness in a range of 0.01 mm to 5 mm. When the thickness of the glass substrate exceeds 5 mm, it takes time to form the penetration hole, and on the other hand, when the thickness is less than 0.01 mm, a problem such as breaking may occur. The thickness of the glass substrate of the present invention is preferably 0.02 mm to 3 mm, and more preferably 0.02 mm to 1 mm. It is particularly preferable that the thickness of the glass substrate is greater than or equal to 0.05 mm and less than or equal to 0.4 mm.

The glass substrate of the present invention includes 40 wt% of SiO₂ or more. The SiO₂ content may be in a range of 50 wt% to 70 wt%, for example. When the SiO₂ content exceeds this range, the possibility of generating cracks at the bottom surface of the glass substrate increases when forming the penetration hole.

The SiO₂ content is more preferably higher than or equal to 55 wt% and lower than or equal to 67 wt%. It is particularly preferable that the SiO₂ content is higher than or equal to 59 wt% and lower than or equal to 62 wt%. Other components are not particularly limited as long as the requirements of the present invention are satisfied, and an arbitrary combination of arbitrary amounts of Al₂O₃, B₂O₃, MgO, CaO, SrO, ZnO, and the like may be used.

It is known that the crack generating behavior of glass differs between the glass having a high SiO₂ content and the glass having a low SiO₂ content, and the glass having an extremely high SiO₂ content may easily generate cone-shaped cracks upon contact with an object and the like. On the other hand, the glass having an extremely low SiO₂ content may easily break upon contact with an object. Accordingly, the glass substrate uneasily breaks and cracks are uneasily generated, by adjusting the SiO₂ content within the glass substrate to the range described above.

The glass substrate of the present invention preferably has a low alkali content (sum total of Li₂O + Na₂O + K₂O), and a sum total of Li₂O (wt%) + Na₂O (wt%) + K₂O (wt%) is preferably 6.0 wt% or lower, and more preferably 3.5 wt% or lower. More particularly, the sum of the Na (sodium) content and the K (potassium) content is preferably 3.5 wt% or lower in oxide-equivalent-content. When the sum exceeds 3.5 wt%, the possibility that the coefficient of thermal expansion exceeds 40 x 10⁻⁷/K increases. The sum of the Na (sodium) content and the K (potassium) content is more preferably 3 wt% or less. When the glass substrate of the present invention is used in a high-frequency device, or when a large number of penetration holes are formed at an extremely narrow pitch, such that a large number of penetration holes that are 50 µm or less are formed at a pitch of 200 µm or less, for example, it is particularly preferable that the glass substrate is no-alkali glass.

The no-alkali glass is intended to mean that a sum total of alkali metal in the glass is less than 0.1 wt% in oxide-equivalent-content.

The glass substrate of the present invention preferably includes substantially no barium. This is because U and Th are likely to be mixed into the raw material of barium. Substantially no barium is intended to mean the following. More particularly, the BaO content is preferably 0.3 wt% or lower, more preferably 0.2 wt% or lower, and particularly preferably 0.01 wt% or lower.

In addition, the glass substrate of the present invention preferably includes substantially no zirconium. This is because U and Th are likely to be mixed into the raw material of zirconium. Substantially no zirconium is intended to mean the following. More particularly, the ZrO₂ content is preferably 0.5 wt% or lower, more preferably 0.2 wt% or lower, particularly preferably 0.1 wt% or lower, and most preferably 0.01 wt% or lower.

The glass substrate of the present invention preferably has a dielectric constant of 6 or smaller at 25°C and 1 MHz. In addition, the glass substrate of the present invention preferably has a dielectric loss of 0.005 or lower at 25°C and 1 MHz. By making the dielectric constant small and the dielectric loss low, superior device characteristics may be exhibited.

The glass substrate of the present invention is preferably glass having a Young's modulus of 70 GPa or higher. By making the Young's modulus higher than or equal to a predetermined value, the rigidity of the glass substrate becomes high, and the strength may be maintained even after the penetration hole is formed. For example, the Young's modulus may be measured by the resonance method.

The glass substrate of the present invention includes a plurality of penetration holes. Each penetration hole may have a circular shape. In this case, the diameter of the penetration hole may differ depending on the usage of the glass substrate of the present invention, but generally, the diameter is preferably in a range of 5 µm to 500 µm. When the glass substrate of the present invention is used as an insulator layer of a multi-layer circuit board described above, the diameter of the penetration hole is preferably 0.01 mm to 0.2 mm, and more preferably 0.02 mm to 0.1 mm. In addition, the WLP (Wafer Level Package) technology may be applied to stack the glass substrate of the present invention on a wafer in order to form an IC chip used for a pressure sensor and the like, and in this case, the diameter of the penetration holes used as air inlets is preferably 0.1 mm to 0.5 mm, and more preferably 0.2 mm to 0.4 mm. Furthermore, in this case, the diameter of the penetration holes used to draw out electrodes, other than the penetration holes used as the air inlets, is preferably 0.01 mm to 0.2 mm, and more preferably 0.02 mm to 0.1 mm. Particularly when the penetration holes are used as penetration electrodes of an interposer and the like, the diameter of the penetration holes is preferably 0.005 mm to 0.075 mm, and more preferably 0.01 mm to 0.05 mm.

As will be described later, in the glass substrate of the present invention, the diameter of the circular penetration hole opening at one surface may be different from the diameter of this circular penetration hole opening at the other surface. In this case, the "diameter of the penetration hole" refers to the larger one of the diameters of the penetration hole opening at the two surfaces.

A ratio (ds/dl) of the larger diameter (d1) and the smaller diameter (ds) is preferably 0.2 to 0.99, and more preferably 0.5 to 0.90.

The number density of the penetration holes in the glass substrate of the present invention may differ depending on the usage of the glass substrate of the present invention, and may generally be in a range of 0.1/mm² to 10,000/mm². When the glass substrate of the present invention is used as the insulator layer of the multi-layer circuit board described above, the number density of the penetration holes is preferably in a range of 3/mm² to 10,000/mm², and more preferably in a range of 25/mm² to 100/mm². In addition, when the glass substrate of the present invention is stacked on the wafer by applying the WLP (Wafer Level Package) technology in order to form the IC chip used for the pressure sensor and the like, the number density of the penetration holes is preferably in a range of 1/mm² to 25/mm², and more preferably in a range of 2/mm² to 10/mm². When the penetration holes are used as the penetration electrodes of the interposer and the like, the number density of the penetration holes is preferably in a range of 0.1/mm² to 1,000/mm², and more preferably in a range of 0.5/mm² to 500/mm²_{.}

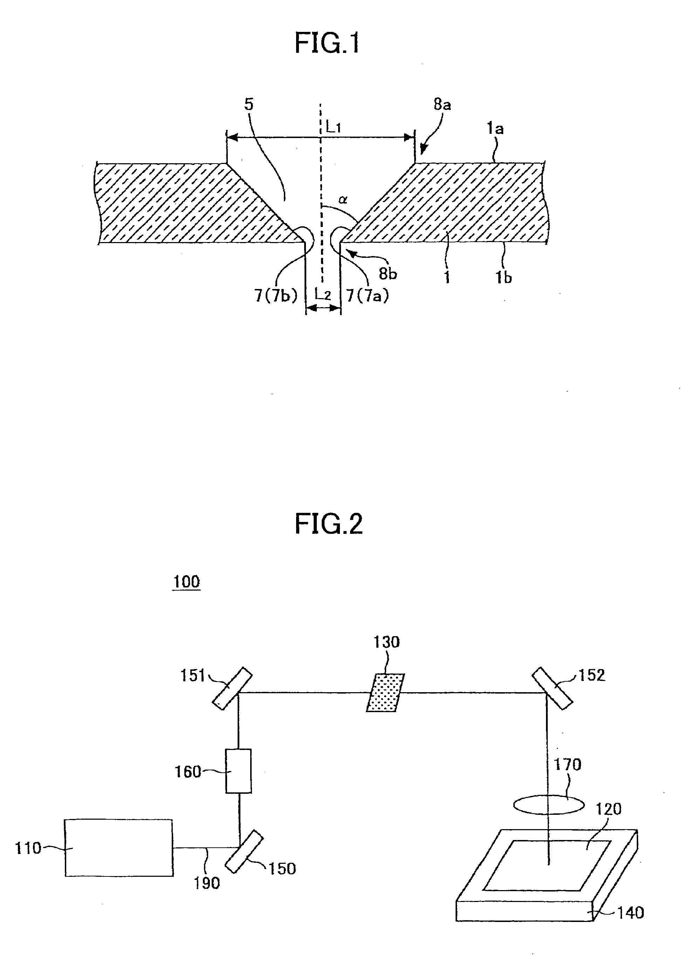

In the glass substrate of the present invention, the cross sectional area of the penetration hole may undergo a monotonic decrease from one surface at which the penetration hole opens to the other surface at which the penetration hole opens. This characterizing feature of the glass substrate of the present invention will be described with reference to FIG. 1.

FIG. 1 is a cross sectional view, on an enlarged scale, illustrating an example of a penetration hole in a glass substrate of the present invention.

As illustrated in FIG. 1, a glass substrate 1 of the present invention includes a first surface 1a and a second surface 1b. In addition, the glass substrate 1 includes a penetration hole 5. This penetration hole 5 penetrates the glass substrate 1 from a first opening 8a provided in a first surface 1a to a second opening 8b provided in a second surface 1b.

The penetration hole 5 has a diameter L1 at the first opening 8a, and has a diameter L2 at the second opening 8b.

The penetration hole 5 has a "taper angle" α. The taper angle α refers to the angle formed by a normal (indicated by a dotted line in FIG. 1) to the first surface 1a (and the second surface 1b) of the glass substrate 1 and a wall surface 7 of the penetration hole 5.

In FIG. 1, the angle formed by the normal to the glass substrate 1 and a right wall surface 7a of the penetration hole 5 is the taper angle α, but the angle formed by the normal to the glass substrate 1 and a left wall surface 7b is also the taper angle α in FIG. 1. Normally, the right taper angle α and the left taper angle α have values that are approximately the same. A difference between the right taper angle α and the left taper angle α may be on the order of 30%.

In the glass substrate of the present invention, the taper angle α is preferably in a range of 0.1° to 20°. In a case in which the penetration hole of the glass substrate has such a taper angle α, a conductive material may be quickly filled into the inside of the penetration hole 5 from the side of the first surface 1a of the glass substrate 1 when forming the electrode in the penetration hole 5 according to the plating method and the like by filling the conductive material such as a metal. In addition, the conductive layers of the printed circuit boards stacked above and below the glass substrate may easily be positively connected via the penetration holes in the glass substrate. The taper angle α is preferably in a range of 0.5° to 10°, and more preferably in a range of 2° to 8°.

As will be described later, the taper angle α may be arbitrarily adjusted according to the method of manufacturing the glass substrate of the present invention.

In this specification, the taper angle α of the penetration hole 5 in the glass substrate 1 may be obtained in the following manner:
Obtain the diameter L1 of the penetration hole 5 at the opening 8a on the side of the first surface 1a of the glass substrate 1;
Obtain the diameter L2 of the penetration hole 5 at the opening 8b on the side of the second surface 1b of the glass substrate 1; and

### Obtain the thickness of the glass substrate 1.

It is assumed that the taper angle α is uniform for all of the penetration holes 5, and the taper angle α is calculated from the above measurements.

The absorption coefficient of the glass substrate of the present invention with respect to the wavelength of the excimer laser light is preferably 3 cm⁻¹ or greater. In this case, the formation of the penetration holes is further facilitated. In order to more effectively absorb the excimer laser light, the iron (Fe) content within the glass substrate is preferably 0.01 mass% or higher, more preferably 0.03 mass% or higher, and particularly preferably 0.05 mass% or higher. On the other hand, when the Fe content is high, the coloring may become stronger, and a problem may occur in which the alignment at the time of the laser beam machining becomes more difficult. The Fe content is preferably 0.2 mass% or lower, and more preferably 0.1 mass% or lower.

The glass substrate of the present invention may be suitably used for semiconductor device parts, and more particularly for the insulator layer of the multi-layer circuit board, the WLP (Wafer Level Package), the penetration holes for drawing out the electrodes, the interposer, and the like.

### (Method of Manufacturing Glass Substrate of Present Invention)

Next, a description will be given of the method of manufacturing the glass substrate of the present invention having the features described above, by referring to FIG. 2.

FIG. 2 is a diagram schematically illustrating an example of a structure of a manufacturing apparatus used by the manufacturing method of the present invention.

As illustrated in FIG. 2, a manufacturing apparatus 100 includes an excimer laser light generating unit 110, a mask 130, and a stage 140. A plurality of mirrors 150 and 151 and a homogenizer 160 are arranged between the excimer laser light generating unit 110 and the mask 130. In addition, another mirror 152 and a projection lens 170 are arranged between the mask 130 and the stage 140.

The mask 130 may have a structure in which a pattern of a reflection layer is arranged on a base material (transparent base material) that is transparent with respect to the laser light, for example. Hence, in the mask 130, a part where the reflection layer is arranged on the transparent base material may block the laser light, and a part where no reflection layer is arranged on the transparent base material may transmit the laser light.

Alternatively, the mask 130 may be formed by a metal plate and the like having penetration openings. For example, materials such as chromium (Cr), stainless steel, and the like may be used for the metal plate.

A glass substrate 120 that is a working target is arranged on the stage 140. The glass substrate 120 may be moved to an arbitrary position by moving the stage 140 two-dimensionally or three-dimensionally.

In the manufacturing apparatus 100 having the structure described above, excimer laser light 190 generated from the excimer laser light generating unit 110 is input to the mask 130 via the first mirror 150, the homogenizer 160, and the second mirror 151. The excimer laser light 190 is adjusted to laser light having a uniform intensity when the excimer laser light 190 passes through the homogenizer 160.

As described above, the mask 130 includes the pattern of the reflection layer on the base material that is transparent with respect to the laser light. For this reason, the excimer laser light 190 is radiated from the mask 130 with a pattern corresponding to the pattern of the reflection layer (more particularly, the parts where no reflection layer is provided).

Thereafter, the direction of the laser light 190 transmitted through the mask 130 is adjusted by the third mirror 152, and is irradiated on the glass substrate 120 supported on the stage 140 through the reduction projection performed by the projection lens 170. The laser light 190 may simultaneously form a plurality of penetration holes in the glass substrate 120.

After the penetration holes are formed in the glass substrate 120, the glass substrate 120 may be moved on the stage 140 before the excimer laser light 190 is again irradiated on the glass substrate 120. Hence, the desired penetration holes may be formed at desired parts on the surface of the glass substrate 120. In other words, the known step-and-repeat method may be applied to this method.

The projection lens 170 preferably irradiates the excimer laser light 190 on the entire work region on the surface of the glass substrate 120 in order to simultaneously form the plurality of penetration holes. Normally, however, it may be difficult to obtain an irradiation fluence capable of simultaneously forming all of the penetration holes. Hence, the excimer laser light 190 transmitted through the mask 130 is actually subjected to the reduction projection performed by the projection lens 170, in order to increase the irradiation fluence of the excimer laser light 190 at the surface of the glass substrate 120, and to secure the irradiation fluence required to form the penetration holes.

By utilizing the reduction projection performed by the projection lens 170, the irradiation fluence may be increased to 10 times when the cross sectional area of the excimer laser light 190 at the surface of the glass substrate 120 is 1/10 the cross sectional area of the excimer laser light 190 immediately after being transmitted through the mask 130. By using a projection lens having a reduction ratio of 1/10 and setting the cross sectional area of the excimer laser light at the substrate surface to 1/100, the irradiation fluence of the excimer laser light at the surface of the glass substrate 120 may be made 100 times that of the excimer laser light immediately after being generated from the excimer laser light generating unit 110.

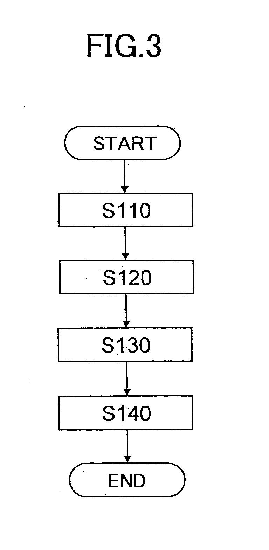

FIG. 3 is a flow chart schematically illustrating an example of the manufacturing method for the glass substrate of the present invention.

As illustrated in FIG. 3, the manufacturing method for the glass substrate of the present invention includes
(1) A step (step S110) to prepare a glass substrate;
(2) A step (step S120) to arrange the glass substrate in an optical path of an excimer laser light from an excimer laser light generating unit;
(3) A step (step S130) to arrange a mask in the optical path between the excimer laser light generating unit and the glass substrate; and
(4) A step (step S140) to irradiate excimer laser light from the excimer laser light along the optical path onto the glass substrate, in order to form penetration holes in the glass substrate.

Next, a description will be given of each of the above steps.

### (Step S110)

First, the glass substrate having an α-count of 0.05 c/cm²·h or lower, including 40 wt% of SiO₂ or more, and having a coefficient of thermal expansion in a range of 20 x 10⁻⁷/K to 40 x 10⁻⁷/K is prepared. A preferable composition and the like of the glass substrate may be as described above.

### (Step S120)

Next, the glass substrate is arranged in the optical path of the excimer laser light from the excimer laser light generating unit. As illustrated in FIG. 2, the glass substrate 120 may be arranged on the stage 140.

The excimer laser light 190 generated from the excimer laser light generating unit 110 may have an oscillation wavelength of 250 nm or less. From the point of view of the output, KrF excimer laser (wavelength of 248 nm), ArF excimer laser (193 nm), or F₂ excimer laser (wavelength of 157 nm) may preferably be used. From the point of view of the handling ease and the absorption of glass, the ArF excimer laser is more preferable.

In addition, when the excimer laser light 190 that is used has a narrow pulse width, the thermal diffusion distance at the irradiated part on the glass substrate 120 becomes short, and the effect of the heat with respect to the glass substrate may be suppressed. From this point of view, the pulse width of the excimer laser light 190 is preferably 100 nsec or less, more preferably 50 nsec or less, and particularly preferably 30 nsec or less.

Moreover, the irradiation fluence of the excimer laser light 190 is preferably 1 J/cm² or higher, and more preferably 2 J/cm² or higher. When the irradiation fluence of the excimer laser light 190 is too low, it may not be possible to induce aberration, and the forming of the penetration holes in the glass substrate may become difficult. On the other hand, when the irradiation fluence of the excimer laser light 190 exceeds 20 J/cm², there is a tendency for the cracks and breaks to be more easily generated in the glass substrate. A preferable range of the irradiation fluence of the excimer laser light 190 may differ depending on the wavelength region of the excimer laser light 190 used, the type of glass substrate that is the working target, and the like, and may preferably be 2 J/cm² to 20 J/cm² in a case of the KrF excimer laser (wavelength of 248 nm). In addition, the preferable range of the irradiation fluence of the excimer laser light 190 may be 1 J/cm² to 15 J/cm² in a case of the ArF excimer laser (wavelength of 193 nm).

Unless specifically described, the value of the irradiation fluence of the excimer laser light 190 refers to the value at the surface of the glass substrate that is the working target. In addition, the value of such an irradiation fluence refers to the value that is measured on a working surface using an energy meter.

### (Step S130)

Next, the mask 130 is arranged between the excimer laser light generating unit 110 and the glass substrate 120.

As described above, the mask 130 may have a structure in which the pattern of the reflection layer is formed on the transparent base material. The material forming the transparent base material is not limited to a particular material as long as the material is transparent with respect to the laser light 190. For example, the material forming the transparent base material may be synthetic silica, fused silica, borosilicate glass, and the like.

On the other hand, the material forming the reflection layer is not limited to a particular material as long as the material has properties to efficiently block the laser light 190. For example, the material forming the reflection layer may be a metal such as chromium, silver, aluminum, and/or gold.

In addition, the size of the mask 130, and the shape, the arrangement and the like of the pattern of the reflection layer of the mask 130 are not particularly limited.

### (Step S140)

Next, the excimer laser light 190 from the excimer laser light generating unit 110 is irradiated on the glass substrate 120 via the mask 130.

When irradiating the excimer laser light 190 on the glass substrate 120, the repetition frequency and the irradiation time of the excimer laser light may be adjusted, in order to adjust the number of shots ([number of shots] = [repetition frequency] x [irradiation time]).

The excimer laser light 190 is preferably irradiated on the glass substrate 120 so that the a product of the irradiation fluence (J/cm²) and the number of shots (times) and the thickness (mm) of the glass substrate becomes in a range of 1,000 to 30,000.

This range may depend on the type of the glass substrate 120 and its characteristics (particularly assumed to be related to a glass transition temperature Tg), but in general, is preferably 1,000 to 20,000, more preferably 2,000 to 15,000, and particularly preferably 3,000 to 10,000. When the product of the irradiation fluence and the number of shots is within such ranges, the cracks are uneasily formed in the glass substrate. The irradiation fluence is preferably 1 J/cm² to 20 J/cm².

In addition, the taper angle α has a tendency to become small when the irradiation fluence of the excimer laser light is large. On the other hand, the taper angle α has a tendency to become large when the irradiation fluence of the excimer laser light is small. Hence, the glass substrate having the penetration holes with the desired taper angle α may be obtained, by adjusting the irradiation fluence. The taper angle α may be in a range of 0.1° to 20°.

The glass substrate for forming the through-substrate via of the semiconductor device may be manufactured by the steps described above.

Normally, the wafer size used for manufacturing a semiconductor circuit is on the order of 6 inches to 8 inches. In addition, in the case in which the reduction projection is performed by the projection lens 170 as described above, the work region at the surface of the glass substrate normally becomes a square having a side on the order of several mm. Accordingly, in order to irradiate the excimer laser light on the entire region of the glass substrate 120, that is the work target, the excimer laser light needs to be moved, or the glass substrate 120 needs to be moved. Preferably, the glass substrate 120 is moved with respect to the excimer laser light, because it is unnecessary to drive an optical system in this case.

In addition, debris (scattered particles) may be generated when the excimer laser light is irradiated on the glass substrate 120. When the debris accumulate within the penetration hole, the quality of the worked glass substrate and the working rate of the glass substrate may deteriorate. Hence, a suction or blow process may be performed simultaneously as the laser irradiation on the glass substrate, in order to remove the debris.

### Embodiments

Next, a description will be given of embodiments (Examples 1 to 3) of the present invention and comparison examples (Examples 4 to 6).

### (Example 1)

Each raw material powder is weighed and mixed in order to obtain a mixed powder that includes 60 wt% of SiO₂, 17 wt% of Al₂O₃, 8 wt% of B₂O₃, 15 wt% of a sum total of MgO + CaO + SrO + ZnO, and 0.05 wt% of Fe₂O₃. BaO, ZrO₂, and alkali metal oxide are not added to the mixed powder. For this reason, the mixed powder includes substantially no Ba and Zr.

As a result of an analysis, the U (uranium) content and the Th (thorium) content within the mixed powder respectively are 5 mass ppb or lower.

This mixed powder is put into a platinum crucible and melted at 1600°C under an atmosphere environment. After cooling, the obtained glass is cut and polished to prepare a glass sample of the Example 1.

Next, the following evaluation is made using the glass sample that is obtained.

### (Measurement of α-count)

The α-ray measuring apparatus (LACS) manufactured by Sumika Chemical Analysis Service, Ltd. is used to measure the α-count. This apparatus measures the α-rays from the sample surface using the proportional counter, and the α-count is measured by converting the pulse current generated by ionization of the gas by the α-rays, and counting the pulses greater than or equal to the threshold value. A measuring area of the glass sample is 924 cm².

As a result of the measurement, the α-count is less than 0.002 (detection limit value).

### (Measurement of Young's Modulus)

The Young's modulus is measured by the resonance method. The glass samples used have a size of 100 mm x 20 mm x 2 mm that is obtained by grinding. The dimensions of the glass samples for the measurement are set to 100 mm x 20 mm x 2 mm.

The Young's modulus of the glass samples obtained as a result of the measurement is 76 GPa.

### (Measurement of Coefficient of Thermal Expansion)

The coefficient of thermal expansion of each sample is measured based on the JIS R3102 (year 1995) as described above. The dimensions of the glass sample for the measurement has a cylindrical rod shape with a 5 mm diameter x 20 mm.

The coefficient of thermal expansion of the glass samples obtained as a result of the measurement is 37 x 10⁻⁷/K.

Table 1 illustrates the glass composition and the measured results for the Example 1.

**[Table 1]**

| Examples | Glass Composition | | | | | | | | Evaluation Results | | |
|---|---|---|---|---|---|---|---|---|---|---|---|
| | SiO₂ | Al₂O₃ | B₂O₃ | MgO +CaO +SrO +ZnO | Li₂O +Na₂O +K₂O | BaO | ZrO₂ | Fe₂O₃ | α-Ray Count (c/cm²·h) | Young' s Modulus (GPa) | Coefficient of Thermal Expansion (10⁻⁷/K) |
| Example 1 | 60 | 17 | 8 | 15 | - | - | - | 0.05 | <0.002 | 76 | 37 |
| Example 2 | 62.1 | 19.1 | 7.3 | 11.5 | - | - | - | 0.05 | <0.002 | 78 | 32 |
| Example 3 | 65 | 10 | 5 | 17 | 3 | - | - | - | <0.002 | 82 | 33 |
| Example 4 | 81 | 2.3 | 12.7 | - | 4 | - | 0.08 | 0.06 | 0.07 | 64 | 33 |
| Example 5 | 58.6 | 16.4 | 8.6 | 7 | - | 9.4 | - | 0.02 | >0.1 | 71 | 39 |
| Example 6 | 59 | 3 | 20 | 2.6 | 15.4 | - | - | - | <0.002 | 66 | 72 |

Hence, according to the glass sample of the Example 1, the amount of α-ray emission is small, and the glass sample may be suitable for use in semiconductor devices and the like that are easily affected by α-rays. In addition, the glass sample of the Example 1 has a relatively high Young's modulus, and the penetration holes may be formed relatively easily by the laser beam machining. Furthermore, the coefficient of thermal expansion of the glass sample of the example is relatively close to that of silicon, and thus, it is possible to provide a glass substrate for forming the through-substrate via of the semiconductor device, having a high affinity with respect to the silicon parts.

### (Example 2)

A glass sample of the Example 2 is made according to a method similar to that used for the Example 1. However, in the Example 2, each raw material powder is weighed and mixed in order to obtain a mixed powder that includes 62.1 wt% of SiO₂, 19.1 wt% of Al₂O₃, 7.3 wt% of B₂O₃, 11.5 wt% of a sum total of MgO + CaO + SrO + ZnO, and 0.05 wt% of Fe₂O₃. For this reason, the mixed powder includes substantially no Ba and Zr.

As a result of an analysis, the U (uranium) content and the Th (thorium) content within the mixed powder respectively are 5 mass ppb or lower.

As a result of the α-count measurement, the α-count of this glass sample is less than 0.002 (detection limit value). In addition, as a result of the measurements, the Young's modulus of this glass samples is 78 GPa, and the coefficient of thermal expansion of this glass samples is 32 x 10⁻⁷/K.

Table 1 illustrates the glass composition and the measured results for the Example 2 in a row thereof.

From these results, according to the glass sample of the Example 2, it is possible to provide a glass substrate for forming the through-substrate via of the semiconductor device, in which the amount of α-ray emission is small, to which the laser beam machining is possible, and having a high affinity with respect to the silicon parts, similarly as in the case of the glass sample of the Example 1.

### (Example 3)

A glass sample of the Example 3 is made according to a method similar to that used for the Example 1. However, in the Example 3, each raw material powder is weighed and mixed in order to obtain a mixed powder that includes 65 wt% of SiO₂, 10 wt% of Al₂O₃, 5 wt% of B₂O₃, 17 wt% of a sum total of MgO + CaO + SrO + ZnO, 3 wt% of a sum total of Li₂O + Na₂O + K₂O and 50 mass ppm (0.005 wt%) of Fe₂O₃. BaO and ZrO₂ are not added to the mixed powder: For this reason, the mixed powder includes substantially no Ba and Zr.

As a result of an analysis, the U (uranium) content and the Th (thorium) content within the mixed powder respectively are 5 mass ppb or lower.

As a result of the α-count measurement, the α-count of this glass sample is less than 0.002 (detection limit value). In addition, as a result of the measurements, the Young's modulus of this glass samples is 82 GPa, and the coefficient of thermal expansion of the glass samples is approximately 33 x 10⁻⁷/K.

Table 1 illustrates the glass composition and the measured results for the Example 3 in a row thereof.

From these results, according to the glass sample of the Example 3, it is possible to provide a glass substrate for forming the through-substrate via of the semiconductor device, in which the amount of α-ray emission is small, to which the laser beam machining is possible, and having a high affinity with respect to the silicon parts, similarly as in the case of the glass sample of the Example 1.

### (Example 4)

A glass sample of the Example 4 is made according to a method similar to that used for the Example 1. However, in the Example 4, each raw material powder is weighed and mixed in order to obtain a mixed powder that includes 81 wt% of SiO₂ 2.3 wt% of Al₂O₃, 12.7 wt% of B₂O₃, 4 wt% of a sum total of Li₂O + Na₂O + K₂O, 0.08 wt% of ZrO₂, and 0.06 wt% of Fe₂O₃. The mixed powder includes substantially no Ba.

As a result of the α-count measurement, the α-count of this glass sample is approximately 0.07. For this reason, it may be anticipated that this glass sample is unsuited for use in a semiconductor device that is easily affected by α-rays.

The Young's modulus of this glass samples is 64 GPa. In the case of the glass having such a Young's modulus, there is a problem in that a deformation or warp may easily be occur due to a stress generated in the penetration electrode, wiring, stacking of the chip, and the like. In addition, the strength of the glass itself may easily deteriorate in the case of the glass having such a Young's modulus.

The coefficient of thermal expansion of this glass samples is 33 x 10⁻⁷/K.

Table 1 illustrates the glass composition and the measured results for the Example 4 in a row thereof.

### (Example 5)

A glass sample of the Example 5 is made according to a method similar to that used for the Example 1. However, in the Example 5, each raw material powder is weighed and mixed in order to obtain a mixed powder that includes 58.6 wt% of SiO₂ 16.4 wt% of Al₂O₃, 8.6 wt% of B₂O₃, 7 wt% of a sum total of MgO + CaO + SrO + ZnO, 9.4 wt% of BaO, and 0.02 wt% of Fe₂O₃.

As a result of the α-count measurement, the α-count of this glass sample exceeds approximately 0.1. For this reason, it may be anticipated that this glass sample is unsuited for use in a semiconductor device that is easily affected by α-rays.

The Young's modulus of this glass samples is 71 GPa, and the coefficient of thermal expansion of this glass samples is 39 x 10⁻⁷/K.

Table 1 illustrates the glass composition and the measured results for the Example 5 in a row thereof.

### (Example 6)

A glass sample of the Example 6 is made according to a method similar to that used for the Example 1. However, in the Example 6, each raw material powder is weighed and mixed in order to obtain a mixed powder that includes 59 wt% of SiO₂, 3 wt% of Al₂O₃, 20 wt% of B₂O₃, 2.6 wt% of a sum total of MgO + CaO + SrO + ZnO, and 15.4 wt% of a sum total of Li₂O + Na₂O + K₂O.

As a result of the α-count measurement, the α-count of this glass sample is approximately 0.002 (detection limit value).

However, the Young's modulus of this glass samples is 66 GPa. In the case of the glass having such a Young's modulus, there is a problem in that a deformation or warp may easily be occur due to the stress generated in the penetration electrode, wiring, stacking of the chip, and the like. In addition, the strength of the glass itself may easily deteriorate in the case of the glass having such a Young's modulus.

The coefficient of thermal expansion of this glass samples is approximately 72 x 10⁻⁷/K. When the glass having such a coefficient of thermal expansion is used as the glass substrate for forming the through-substrate via of the semiconductor device and the semiconductor device receives the stress, a contact failure may occur between the conductive parts, or the semiconductor device itself may be damaged, due to the mismatch between the coefficient of thermal expansion of the glass substrate and the coefficient of thermal expansion of the silicon chip. Hence, it may be regarded that the application of the glass sample of the Example 7 to the glass substrate for forming the through-substrate via of the semiconductor device is difficult.

Table 1 illustrates the glass composition and the measured results for the Example 6 in a row thereof.

The present invention is described above in detail with reference to specific embodiments, however, it may be apparent to those skilled in the art that various variations and modifications may be made without departing from the spirit and scope of the present invention.

This application is based on a Japanese Patent Application No. 2010-097228 filed on April 20, 2010, the disclosure of which is hereby incorporated by reference.

### INDUSTRIAL APPLICABILITY

The present invention may be applied to glass substrates preferably usable for parts of semiconductor devices, more particularly, insulator layers of multi-layer circuit boards, wafer level packages, penetration holes for drawing out electrodes, interposers, and the like.

### DESCRIPTION OF REFERENCE NUMERALS

- 1: Glass Substrate
- 1a: First Surface
- 1b: Second Surface
- 1c: Wall Surface
- 5: Penetration Hole
- 7: Wall Surface
- 8a: First Opening
- 8b: Second Opening
- α: Taper Angle
- L1: Diameter of First Opening of Penetration Hole
- L2: Diameter of Second Opening of Penetration Hole
- 100: Manufacturing Apparatus
- 110: Excimer Laser Light Generating Unit
- 120: Glass Substrate
- 130: Mask
- 140: Stage
- 150 - 152: Mirror
- 160: Homogenizer
- 170: Projection Lens

## Claims

1. A glass substrate for forming a through-substrate via of a semiconductor device, **characterized in that** there are provided:
a plurality of penetration holes,
wherein an α-count is 0.05 c/cm²·h or less,
a SiO₂ content is 40 wt% or higher, and a sum total content of Li₂O (wt%) + Na₂O (wt%) + K₂O (Wt%) is 6.0 wt% or lower, and
an average coefficient of thermal expansion at 50°C to 350°C is in a range of 20 x 10⁻⁷/K to 40 x 10⁻⁷/K.

2. The glass substrate as claimed in claim 1, **characterized in that** the glass substrate includes substantially no barium.

3. The glass substrate as claimed in claim 1 or 2, **characterized in that** the glass substrate includes a sum total content of Li₂O (wt%) + Na₂O (wt%) + K₂O (Wt%) that is 3.5 wt% or lower.

4. The glass substrate as claimed in any of claims 1 to 3, **characterized in that** the glass substrate has a Young's modulus of 70 GPa or higher.

5. The glass substrate as claimed in any of claims 1 to 4, **characterized in that** the plurality of penetration holes have a tapered shape having a taper angle in a range of 0.1 ° to 20°.
